# EUROPEAN PATENT SPECIFICATION

(11) **EP 1 344 313 B1**
(45) Date of publication and mention of the grant of the patent: **02.01.2008**
(21) Application number: 01983026.4
(22) Date of filing: 09.11.2001
(51) Int. Cl.: H03F 3/189

(54) **MICROWAVE AMPLIFIER WITH BYPASS SEGMENT**
MIKROWELLENVERSTÄRKER MIT BYPASS-SEGMENT
AMPLIFICATEUR DE MICRO-ONDES DOTE D'UN SEGMENT DE DERIVATION

(30) Priority: 22.12.2000 SE 0004834
(43) Date of publication of application: 17.09.2003
(73) Proprietor: ALLGON AB, 187 80 Täby (SE)
(72) Inventor: POZDEEV, Oleg, S-184 37 Akersberga (SE)
(74) Representative: Modin, Jan
(86) International application number: PCT/SE2001/002490
(87) International publication number: WO 2002/052722

(56) References cited:
- US-A- 3 992 669
- US-A- 4 056 785
- US-A- 5 418 490

## Description

### FIELD OF THE INVENTION

The present invention relates to a device for amplifying communication signals in a predetermined microwave frequency band above 500 MHz. A bypass segment is automatically activated when the amplifier unit becomes inoperative, e.g. due to failure of some RF component or DC failure, and is effectively blocked during normal operation of the amplifier unit. More particularly, the device is of the kind defined in the preamble of appended claim 1.

### BACKGROUND OF THE INVENTION AND RELATED ART

A device of the aforementioned kind is disclosed in US-A-5,821,811 (Allgon AB). In the known device, the amplifier unit forms a closed loop together with the bypass segment. In case the isolation across the bypass segment in active mode is lower than the amplifier gain, there is a risk of instability due to feedback through the bypass segment.

In order to secure sufficient stability, the isolation in the bypass segment should be at least 10 dB higher than the gain of the amplifier unit in active mode. When using the previously known device, which is provided with pin diodes as switching elements, it is necessary to use more than two switching elements, normally four switching elements to achieve an isolation of 30 dB. However, such an arrangement also leads to a relatively high insertion loss in the bypass mode of the device, namely in the order of 2 dB. This level is a drawback, since it adversely effects the operation of the device in the bypass mode.

A related problem of an amplifier/bypass device of the aforementioned kind is the difficulty in ensuring a proper operation of the device in active mode. Thus, it is desired to maintain a low noise factor and to avoid input/output reflections in the amplifier unit.

Such noise will appear even if two identical low noise amplifiers (LNA) are inserted in a balanced configuration between an input hybrid coupler and an output hybrid coupler, as is previously known per se from US-A-4,825,177 (General Instrument Corporation). This is due to the fact that the bypass segment will alter the balance of the amplifier unit.

A protection circuit which uses a diode as switching element and which short-circuits the by-pass path in normal mode is disclosed in US 3992699.

### SUMMARY OF THE INVENTION

Accordingly, a general object of the present invention is to provide an improved device of the aforementioned kind, which operates properly in the active mode as well as in the bypass mode.

More specifically, a first object of the invention is to increase the bypass isolation in the active mode and to reduce the insertion loss in the bypass segment in the bypass mode.

A second specific object of the invention is to reduce the noise factor and to reduce input/output reflections in the amplifier unit, when operating in active mode.

The above mentioned first object is achieved for a device having the features stated in claim 1. Thus, the bypass segment of the device according to a first aspect of the invention comprises at least one section of coupled transmission lines, whereby the isolation against feedback through the bypass segment is improved.

By this measure, it is sufficient to include only two switching elements and still obtain a drastically improved isolation of about 55 dB (when using pin diodes as in the prior art device) in the active mode and a bypass insertion loss of only 1 dB in the bypass mode.

According to a second aspect of the invention, the above-mentioned second object is attained for a device having the features stated in claim 6.

Preferably, the input impedance of the bypass segment, in said active mode of the device, is at least an order of magnitude higher than the input impedance of the amplifier unit (typically 50 ohm). In this way, the two low noise amplifiers, arranged in a balanced configuration to form the amplifier unit, are balanced through a wide frequency band, even for frequencies above the predetermined microwave frequency band. Advantageously, such a relatively high input impedance of the bypass segment (in active mode) is combined with the above-mentioned section of mutually coupled transmission lines. Accordingly, it is hereby possible to achieve an increased isolation and stability, a low noise factor and a reduction of the input/output reflections in the amplifier unit when operating in active mode, as well as a reduced insertion loss in the bypass segment when operating in bypass mode.

These and other features will be apparent from the detailed description below.

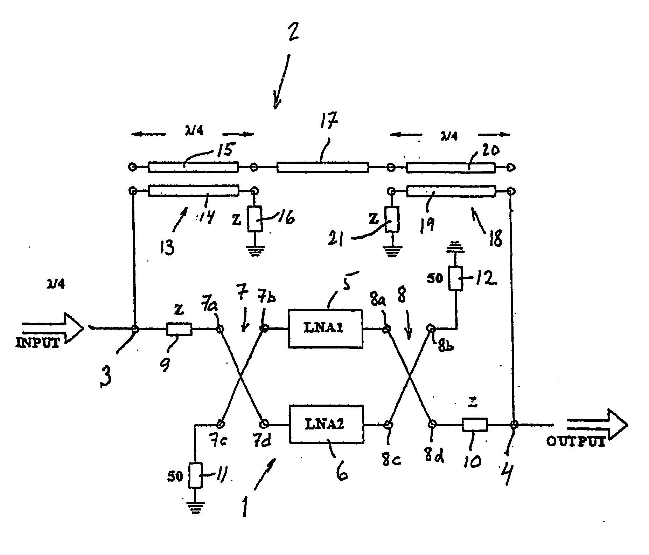

### BRIEF DESCRIPTION OF THE DRAWING

The invention will be explained more fully below with reference to the appended drawing which illustrates a preferred embodiment of the device according to the invention.

The single drawing figure illustrates schematically an amplifier device with a bypass segment in accordance with the present invention (on a printed circuit board which is not shown on the drawing).

### DESCRIPTION OF A PREFERRED EMBODIMENT

The circuitry shown on the drawing comprises an amplifier unit 1 with a bypass segment 2 for use, e.g., in combination with an antenna, duplex means, and band-pass filters at the top of an antenna mast or tower in a cellular mobile telephone system, as explained in the above-mentioned US-A-5,821,811.

The amplifier unit 1 has the task of amplifying received communication signals, in a predetermined microwave frequency band in a frequency range above 500 MHz, before these signals become significantly attenuated along a transmission line (not shown) to a base station located adjacent to the bottom of the antenna mast or tower.

The amplifier unit 1 is inserted between an input port 3 and an output port 4, the bypass segment 2 being arranged in parallel to the amplifier unit 1, likewise between the input and output ports 3,4.

As previously known per se (see the above-mentioned US-A-4,825,177), the amplifier unit comprises two low noise amplifiers (LNA) 5,6 arranged in parallel between an input hybrid coupler 7 and an output hybrid coupler 8. An input hybrid port 7a is connected to the input port 3 via a switching element 9, whereas an output hybrid port 8d is connected to the output port 4 via a switching element 10. An isolated port 7c of the input hybrid coupler 7 is connected to ground via a 50 ohm impedance element 11, and the other output port 8b is likewise connected to ground via a 50 ohm impedance element 12.

So, the two amplifiers 5,6 are single-ended and are coupled between the input and output ports 3,4 in a fully balanced configuration. In the normal operation of the device, during which the four switching elements 9,10,16,21 are controlled to a very low impedance value, the input signal appearing on the input hybrid port 7a is coupled in equal proportions to the hybrid output ports 7b,7d, whereas the output signals from the amplifiers 5,6 are coupled from the hybrid ports 8a,8c to the hybrid output port 8d and the output port 4 via the switching element 10. Preferably, the hybrid couplers 7 and 8 are constituted by Lange couplers or modified Lange couplers, e.g. of the kind described in the Swedish patent application concerning a "4-port hybrid coupler" filed by same applicant, Allgon AB, on the same day as the present patent application. However, it is also possible to use any other 3 dB 90 degrees hybrid coupler.

Thanks to the balanced configuration of the two low noise amplifiers 5,6, the amplifier unit 1 is operative in a relative broad frequency band with a substantially constant gain.

According to the present invention, the bypass segment 2 is designed so as to increase the stability of the device and also to secure a substantially balanced operation of the amplifier unit in spite of the bypass segment.

In order to achieve a good stability and to avoid a possible feed-back through the bypass segment 2, the latter is provided with two sections of coupled transmission lines, a first section 13 including a first transmission line 14 and a second transmission line 15. The first transmission line 14 is connected between the input port 3 of the device and a switching element 16, the impedance of which is automatically and/or remotely controllable, e.g. by a control circuit (not shown) located in the amplifier/bypass device or at an associated base station.

As disclosed in the above-mentioned US-A-5,821,811, such a controllable switching element may be constituted by a diode, a bipolar transistor, a field effect transistor or an electromechanical relay. In any case, the switching element 16 is switched between a very high impedance, such as 5 kohm, and a relatively low impedance, such as 1-10 ohm.

When the switching elements 9,10,16,21 are controlled to a state of very high impedance, which is the case when the amplifier unit is inoperable for one reason or another (bypass mode), e.g. due to a failure of a RF component or a failure of the DC current driving the unit, the transmission line 14 will be electrically open ended (its length being ¼ of the wavelength possibly added with a number N of half wavelengths, N=0,1,2,..) and will therefore couple strongly to the adjacent, parallel transmission line 15. The wavelength refers to a frequency within the microwave frequency band being used, e.g. a central frequency in such a band.

A communication signal applied to the input port 3 will therefore propagate via the first section 13 of coupled transmission lines 14,15, via a third, centrally located bypass segment section 17, and via a second section 18 of coupled transmission lines 19,20. The latter section 18 is identical to the first section 13 and the transmission line 19 is connected between the output port 4 of the device and a remotely controllable switching element 21 similar or identical to the element 16. The four switching elements 9,10,16,21 are controlled in synchronism so as to be either in a high impedance state or in a low impedance state at the same time.

However, when the amplifier unit 1 operates normally (active mode), the four switching elements 9,10,16,21 are controlled to a state of relatively low impedance, whereby the bypass segment is cut off. An input signal on the input port 3 will then propagate through the amplifiers 5,6 to the output port 4. In the illustrated embodiment, the isolation across the bypass segment 2 is very high, approximately 55 dB, and there is no risk of feedback.

On the other hand, in the bypass mode the insertion loss in the bypass segment 2 is very low, approximately 1 dB.

Furthermore, in active mode, thanks to the low impedance of the associated switching elements 16 and 21 in the bypass segment, the bypass input impedance in this active mode is relatively high, whereby the balanced operation of the two low noise amplifiers 5,6 is maintained. Irrespective of the state of the hybrid couplers 7,8, such a balanced operation will be retained since the effective input and output loads of the amplifiers 5,6 are unaffected by the bypass segment. Consequently, the noise factor is very low, and the input and output reflections are likewise low.

## Claims

1. A device for amplifying communication signals in a predetermined microwave frequency band above 500 MHz, comprising a printed circuit board, PCB, with transmission line segments arranged between an input port (3) and an output port (4), an amplifier unit (1) with at least one low noise amplifier (5,6), LNA, a bypass segment (2) extending in parallel to said amplifier unit, and switching elements (9,10,16,21) for activating said bypass segment in a bypass mode of the device, in case said amplifier unit becomes inoperable, and for effectively blocking the bypass segment in an active mode of the device, said bypass segment comprising a series of at least two segment sections (13,18) having at least one junction point connected to an associated one of said switching elements (16,21),
**characterized in that**
- said bypass segment (2) comprises at least one section (13) of coupled transmission lines (14,15),
- whereby the isolation against feedback through the bypass segment is improved.

2. The device defined in claim 1, wherein
- said bypass segment (2) comprises two bypass segment sections each comprising a section (13,18) of coupled transmission lines,
- a first transmission line (14) in a first section (13) being inserted between said input port (3) of the device and an associated switching element (16), and
- a second transmission line (15) in said first section (13) being connected to another one (17) of said series of bypass segment sections,
- a first transmission line (19) in a second section (18) being inserted between said output port (4) of the device and an associated switching element (21), and
- a second transmission line (20) in said second section being connected to another one (17) of said series of bypass segment sections.

3. The device defined in claim 2, wherein
- said second transmission lines (15,20) in said first and second segment sections (13,18) are conductively connected to each other.

4. The device defined in claim 3, wherein
- said second transmission lines (15,20) are connected to each other via a third bypass segment section (17).

5. The device defined in any one of claims 1-4
- wherein each of said transmission lines (14,15,19,20) has a length of substantially a quarter wavelength.

6. A device for amplifying communication signals in a predetermined microwave frequency band above 500 MHz, comprising a printed circuit board, PCB, with transmission line segments arranged between an input port (3) and an output port (4), an amplifier unit (1) with at least one low noise amplifier (5,6), LNA, a bypass segment (2) extending in parallel to said amplifier unit, and switching elements (9,10,16,21) for activating said bypass segment in a bypass mode of the device, in case said amplifier unit becomes inoperable, and for effectively blocking the bypass segment in an active mode of the device, said bypass segment comprising a series of at least two segment sections (13,18) having at least one junction point connected to an associated one of said switching elements (16,21),
**characterized in that**
- said amplifier unit (1) comprises a pair of identical low noise amplifiers LNAs (5,6) arranged in parallel in a symmetrical, balanced configuration, including an input hybrid coupler (7) connected to said input port (3) and an output hybrid coupler (8) connected to said output port (4), and
- said bypass segment (2) has an input impedance in said active mode of the device, which is substantially higher than the input impedance of the device, at said input port (3),
- whereby a balanced operation of said amplifier unit (1) is maintained in said active mode.

7. The device defined in claim 6, provided with a bypass segment as defined in any one of claims 1-5.

8. The device defined in claim 6 or 7, wherein
- said input and output hybrid couplers (7,8) are connected to said input and output ports (3,4) via associated switching elements (9,10).

9. The device defined in any one of claims 6-8, wherein
- said two LNAs (5,6) are single-ended.

10. The device defined in any one of claims 6-9,
- wherein the input impedance of the bypass segment (2) is at least an order of magnitude higher than the input impedance of said amplifier unit (1).

11. The device defined in any one of the preceding claims,
- wherein the impedance of said switching elements (16,21, 9,10) is remotely controllable.

## Patentansprüche

1. Vorrichtung zum Verstärken von Kommunikationssignalen in einem vorbestimmten Mikrowellenfrequenzband oberhalb von 500 MHz mit einem gedruckten Schaltkreis, PCB, mit Übertragungsleitungssegmenten, die zwischen einem Eingangsanschluß (3) und einem Ausgangsanschluß (4) angeordnet sind, einer Verstärkereinheit (1) mit wenigstens einem rauscharmen Verstärker (5, 6), LNA, einem Bypass-Segment (2), das sich parallel zur Verstärkereinheit erstreckt, und Schaltelementen (9, 10, 16, 21) zum Aktivieren des Bypass-Segments in einem Bypass-Modus der Vorrichtung, im Fall daß die Verstärkereinheit ausfällt, und zum wirksamen Blockieren des Bypass-Segments in einem aktiven Modus der Vorrichtung, wobei das Bypass-Segment eine Reihe von wenigstens zwei Segmentabschnitten (13, 18) aufweist, mit wenigstens einem Verbindungspunkt, der mit einem zugehörigen Verbindungspunkt der Schaltelemente (16, 21) verbunden ist,
**dadurch gekennzeichnet, daß**
- das Bypass-Segment (2) wenigstens einen Abschnitt (13) gekoppelter Übertragungsleitungen (14, 15) aufweist,
- wodurch die Isolation gegen Feedback durch das Bypass-Segment verbessert wird.

2. Vorrichtung nach Anspruch 1, worin
- das Bypass-Segment (2) zwei Bypass-Segmentabschnitte aufweist, die je einen Abschnitt (13, 18) von gekoppelten Übertragungsleitungen aufweisen,
- wobei eine erste Übertragungsleitung (14) in einem ersten Abschnitt (13) zwischen dem Eingangsanschluß (3) der Vorrichtung und einem zugehörigen Schaltelement (16) eingefügt ist, und
- eine zweite Übertragungsleitung (15) in dem ersten Abschnitt (13) mit einem anderen Abschnitt (17) der Reihe von Bypass-Segmentabschnitten verbunden ist,
- eine erste Übertragungsleitung (19) in einem zweiten Abschnitt (18) zwischen dem Ausgangsanschluß (4) der Vorrichtung und einem zugehörigen Schaltelement (21) eingefügt ist, und
- eine zweite Übertragungsleitung (20) in dem zweiten Abschnitt mit einem anderen Abschnitt (17) der Reihe von Bypass-Segmentabschnitten verbunden ist.

3. Vorrichtung nach Anspruch 2, worin
- die zweiten Übertragungsleitungen (15, 20) in den ersten und zweiten Segmentabschnitten (13, 18) leitend miteinander verbunden sind.

4. Vorrichtung nach Anspruch 3, worin
- die zweiten Übertragungsleitungen (15, 20) miteinander über einen dritten Bypass-Segmentabschnitt (17) verbunden sind.

5. Vorrichtung nach einem der Ansprüche 1 bis 4, worin
- jede der Übertragungsleitungen (14, 15, 19, 20) eine Länge von im wesentlichen einer Viertel Wellenlänge hat.

6. Vorrichtung zum Verstärkern von Kommunikationssignalen in einem vorbestimmten Mikrowellenfrequenzband oberhalb 500 MHz mit einer gedruckten Schaltung, PCB, mit Übertragungsleitungssegmente, die zwischen einem Eingangsanschluß (3) und einem Ausgangsanschluß (4) angeordnet sind, einer Verstärkereinheit (1) mit wenigstens einem rauscharmen Verstärker (5, 6), LNA, einem Bypass-Segment (2), das sich parallel zur Verstärkereinheit erstreckt, und Schaltelementen (9, 10, 16, 21) zum Aktivieren des Bypass-Segments in einem Bypass-Modus der Vorrichtung, im Fall die Verstärkereinheit ausfällt, und zum wirksamen Blockieren des Bypass-Segments in einem aktiven Modus der Vorrichtung, wobei das Bypass-Segment eine Reihe von wenigstens zwei Segmentabschnitten (13, 18) mit wenigstens einem Verbindungspunkt aufweist, der mit einem zugehörigen der Schaltelemente (16, 21) verbunden ist,
**dadurch gekennzeichnet, daß**
- die Verstärkereinheit (1) ein Paar von identischen rauscharmen Verstärkern LNAs (5, 6), aufweist, die parallel in einer symmetrischen ausgeglichenen Konfiguration angeordnet sind, einschließlich eines Eingangshybridkopplers (7), der mit dem Eingangsanschluß (3) verbunden ist, und eines Ausgangshybridkopplers (8), der mit dem Ausgangsanschluß (4) verbunden ist, und
- das Bypass-Segment (2) in dem aktiven Modus der Vorrichtung eine Eingangsimpedanz hat, die wesentlich höher als die Eingangsimpedanz der Vorrichtung am Eingangsanschluß (3) ist,
- wodurch ein symmetrischer Betrieb der Verstärkereinheit (1) im aktiven Modus aufrechterhalten wird.

7. Vorrichtung nach Anspruch 6, die mit einem Bypass-Segment wie in einem der Ansprüche 1 bis 5 definiert, ausgerüstet ist.

8. Vorrichtung nach Anspruch 6 oder 7, worin
- die Eingangs- und Ausgangshybridkoppler (7, 8) mit den Eingangs- und Ausgangsanschlüssen (3, 4) über zugehörige Schaltelemente (9, 10) verbunden sind.

9. Vorrichtung nach einem der Ansprüche 6 bis 8, worin
- die zwei LNAs (5, 6) einpolig sind.

10. Vorrichtung nach einem der Ansprüche 6 bis 9, worin
- die Eingangsimpedanz des Bypass-Segments (2) wenigstens eine Größenordnung höher als die Eingangsimpedanz der Verstärkereinheit (1) ist.

11. Vorrichtung nach einem der vorangehenden Ansprüche, worin
- die Impedanz der Schaltelemente (16, 21, 9, 10) fernsteuerbar ist.

## Revendications

1. Dispositif destiné à amplifier des signaux de communication dans une bande hyperfréquences prédéterminée supérieure à 500 MHz, comprenant une carte de circuit imprimé (PCB : printed circuit board), avec des segments de ligne de transmission agencés entre une borne d'entrée (3) et une borne de sortie (4), une unité formant amplificateur (1) avec au moins un amplificateur à faible bruit (LNA : low noise amplifier) (5, 6), un segment de dérivation (2) s'étendant parallèlement à ladite unité formant amplificateur et des éléments de commutation (9, 10, 16, 21) destinés à activer ledit segment de dérivation dans un mode de dérivation du dispositif, dans le cas où ladite unité formant amplificateur ne peut être mise en fonctionnement, et pour bloquer efficacement le segment de dérivation dans un mode actif du dispositif, ledit segment de dérivation comprenant une série d'au moins deux sections (13, 18) de segment ayant au moins un point de liaison raccordé à un élément associé parmi lesdits éléments de commutation (16, 21),
**caractérisé en ce que** :
■ ledit segment de dérivation (2) comprend au moins une section (13) de lignes de transmission (14, 15), couplées,
■ moyennant quoi l'isolation contre une contre-réaction, au travers du segment de dérivation, est améliorée.

2. Dispositif selon la revendication 1, dans lequel :
■ ledit segment de dérivation (2) comprend deux sections de dérivation comprenant chacune une section (13, 18) de lignes de transmission couplées,
■ une première ligne de transmission (14) dans une première section (13) étant insérée entre ladite borne d'entrée (3) du dispositif et un élément de commutation (16) associé, et
■ une seconde ligne de transmission (15) dans ladite première section (13) étant connectée à une autre section (17) parmi ladite série de sections de segment de dérivation,
■ une première ligne de transmission (19) dans une seconde section (18) étant insérée entre ladite borne de sortie (4) du dispositif et un élément de commutation (21) associé, et
■ une seconde ligne de transmission (20) dans ladite seconde section étant connectée à une autre section (17) parmi ladite série de sections de segment de dérivation.

3. Dispositif selon la revendication 2, dans lequel :
■ lesdites secondes lignes de transmission (15, 20) dans lesdites première et seconde sections (13, 18) de segment sont raccordées de manière conductrice entre elles.

4. Dispositif selon la revendication 3, dans lequel :
■ lesdites secondes lignes de transmission (15, 20) sont raccordées entre elles par le biais d'une troisième section (17) de segment de dérivation.

5. Dispositif selon l'une quelconque des revendications 1 à 4,
■ dans lequel chacune parmi lesdites lignes de transmission (14, 15, 19, 20) a une longueur égale sensiblement à un quart de longueur d'onde.

6. Dispositif destiné à amplifier des signaux de communication dans une bande hyperfréquences prédéterminée supérieure à 500 MHz, comprenant une carte de circuit imprimé PCB, avec des segments de ligne de transmission agencés entre une borne d'entrée (3) et une borne de sortie (4), une unité formant amplificateur (1) avec au moins un amplificateur à faible bruit (LNA) (5, 6), un segment de dérivation (2) s'étendant en parallèle à ladite unité formant amplificateur et des éléments de commutation (9, 10, 16, 21) destinés à activer ledit segment de dérivation dans un mode de dérivation du dispositif, dans le cas où ladite unité formant amplificateur ne peut être mise en fonctionnement, et pour bloquer efficacement le segment de dérivation dans un mode actif du dispositif, ledit segment de dérivation comprenant une série d'au moins deux sections (13, 18) de segment ayant au moins un point de liaison raccordé à un élément associé parmi lesdits éléments de commutation (16, 21),
**caractérisé en ce que** :
■ ladite unité formant amplificateur (1) comprend une paire d'amplificateurs à faible bruit LNA (5, 6) identiques agencés parallèlement selon une configuration équilibrée, symétrique, comportant un coupleur hybride d'entrée (7) raccordé à ladite borne de sortie (3) et un coupleur hybride de sortie (8) raccordé à ladite borne de sortie (4), et
■ ledit segment de dérivation (2) a une impédance d'entrée dans ledit mode actif du dispositif, qui est sensiblement plus élevée que l'impédance d'entrée du dispositif, au niveau de ladite borne d'entrée (3),
■ moyennant quoi un fonctionnement équilibré de ladite unité formant amplificateur (1) est maintenu dans ledit mode actif.

7. Dispositif selon la revendication 6, prévu avec un segment de dérivation comme défini selon l'une quelconque des revendications 1 à 5.

8. Dispositif selon la revendication 6 ou 7, dans lequel :
■ lesdits coupleurs hybrides d'entrée et de sortie (7, 8) sont raccordés auxdites bornes d'entrée et de sortie (3, 4) par le biais d'éléments de commutation (9, 10) associés.

9. Dispositif selon l'une quelconque des revendications 6 à 8, dans lequel
■ lesdits deux LNA (5, 6) sont à sortie unique.

10. Dispositif selon l'une quelconque des revendications 6 à 9,
■ dans lequel l'impédance d'entrée du segment de dérivation (2) est au moins d'un ordre de grandeur plus élevé que l'impédance d'entrée de ladite unité formant amplificateur (1).

11. Dispositif selon l'une quelconque des revendications précédentes,
■ dans lequel l'impédance desdits éléments de commutation (16, 21, 9, 10) peut être commandée à distance.
